# EUROPEAN PATENT SPECIFICATION

(11) **EP 0 433 936 B1**
(45) Date of publication and mention of the grant of the patent: **10.01.1996**
(21) Application number: 90124392.3
(22) Date of filing: 17.12.1990
(51) Int. Cl.: H01J 49/04

(54) **A valve and membrane device**
Ventil- und Membranvorrichtung
Dispositif à soupape et membrane

(30) Priority: 22.12.1989 US 455472
(43) Date of publication of application: 26.06.1991
(73) Proprietor: THE DOW CHEMICAL COMPANY, Midland, Michigan 48641-1967 (US)
(72) Inventor: LaPack, Mark A., Midland, Michigan 48640 (US); Tou, James C., Midland, Michigan 48640 (US)
(74) Representative: Sternagel, Hans-Günther, Dr.

(56) References cited:
- EP-A- 0 103 988
- INSTRUMENTS AND EXPERIMENTAL TECHNIQUES. vol. 27, no. 3, June 1984, NEW YORK US pages 766 - 767; A.A. RIVLIN ET AL: "Admission of volatile organic impurities from water into a mass spectrometer"
- INTERNATIONAL JOURNAL OF MASS SPECTROMETRY AND ION PHYSICS. vol. 52, no. 2/3, September 1983, AMSTERDAM NL pages 267 - 287; G.E. SPANGLER ET AL: "Membrane inlet for ion mobility spectrometry (plasma chromatography)"
- KLIMAAT BEHEERSING. vol. 17, no. 3, March 1988, DOETINCHEM NL pages 104 - 109; R.A.M. OGINK: "Monsterneming bij meting van NOx - emissies"

## Description

Membrane cells are used in chemical analysis to partition a sample contained on one side of a membrane from a compartment positioned on the other side of the membrane. The sample contains a component of interest that permeates through, i.e., across, the membrane into the compartment. The permeated component of interest in this compartment can then be analyzed. If the sample contains another component that does not permeate through the membrane which otherwise would interfere with the analysis of the component of interest, then the use of a membrane cell in the analysis of the component of interest is beneficial.

Membrane cells can use sheet type membranes or tubular type membranes. A cell using a sheet type membrane can be made by clamping the membrane between two housing portions, each portion having a cavity exposed to the membrane. The cavities are in a juxtaposed position such that they face the membrane. A sample containing a component of interest is placed in one of the cavities. The component of interest permeates through the membrane into the other cavity. The contents of the other cavity are then analyzed for the permeated component of interest. A cell using a tubular type membrane can be made by sealing the outer end portions of a tubular membrane to the inner end portions of a metal tube leaving an annular space between the central portion of the inside of the metal tube and the central portion of the outside of the tubular membrane. A sample containing a component of interest can be placed in the annular space.

The component of interest permeates through the membrane into the bore of the membrane. The contents of the bore of the membrane are then analyzed for the permeated component of interest. Conversely, the sample can be placed in the bore of the tubular membrane and the contents of the annular space can be analyzed.

One important application of membranes in chemical analysis is in the field of mass spectrometry. The membrane of a membrane cell is used to partition a sample from the vacuum inlet of a mass spectrometer. A component of interest of the sample placed on one side of the membrane permeates across the membrane, passes into the partial vacuum on the other side of the membrane as a gas or vapor and is flowed into the mass spectrometer for analysis. Usually, a valve is placed in the vacuum line between the membrane cell and the mass spectrometer so that passage of the component of interest into the mass spectrometer can be stopped if desired.

The "International Journal of mass spectrometry and ion Physics", Vol.52, No. 2/3, September 1983 discloses a membrane device corresponding to the introductory portion of claim 1, said device being adapted to be connected to a mass spectrometer.

Frequently, several membrane cells are connected to a mass spectrometer through such valves so thateach can be respectively analyzed in turn. It would be an advance in this art if the valve and the membrane cell could be combined into one device to reduce the number of apparatus components needed.

The present invention resides in a valve and membrane device, comprising: (a) a semipermeable membrane having a first side and a second side; (b) a valve body defining a cavity therein, said cavity being partitioned by the membrane into a first cavity portion exposed to said first side of said membrane and a second cavity portion exposed to said second side of said membrane, said valve body having first, second and third passageways extending thereinto, said first and second passageways opening into said first cavity portion, said third passageway opening into said second cavity portion for flow of a fluid through said first passageway into said first cavity portion and then through said second passageway and for permeation of a fluid component across said membrane into said second cavity portion for flow out of said valve body through said third passageway; and (c) means positioned within said cavity for controlling the flow of said fluid component through said third passageway.

When used in a mass spectrometry system, the third passageway is connected to the vacuum inlet of the mass spectrometer. A sample is flowed into the first passageway, into the first cavity portion, where it comes into contact with the membrane, and is then passed out the second passageway. When the third passageway is open, a component of the sample that has permeated across the membrane into the second cavity portion flows as a gas or vapor into the vacuum inlet of the mass spectrometer.
Fig. 1 is a cross-sectional side view of a device according to the present invention, the device incorporating a sheet type membrane;
Fig. 2 is a cross-sectional top view of the device shown in Fig. 1 when taken along section line 2-2 of Fig. 1;
Fig. 3 is a cross-sectional side view of a device according to the present invention, the device incorporating a tubular membrane;
Fig. 4 is a cross-sectional top view of the device shown in Fig. 3 when taken along section line 4-4 of Fig. 3;
Fig. 5 is a cross-sectional enlarged side view of one means of sealing a tubular membrane to the body of the device;
Fig. 6 is a cross-sectional enlarged side view of another means of sealing a tubular membrane to the body of the device.

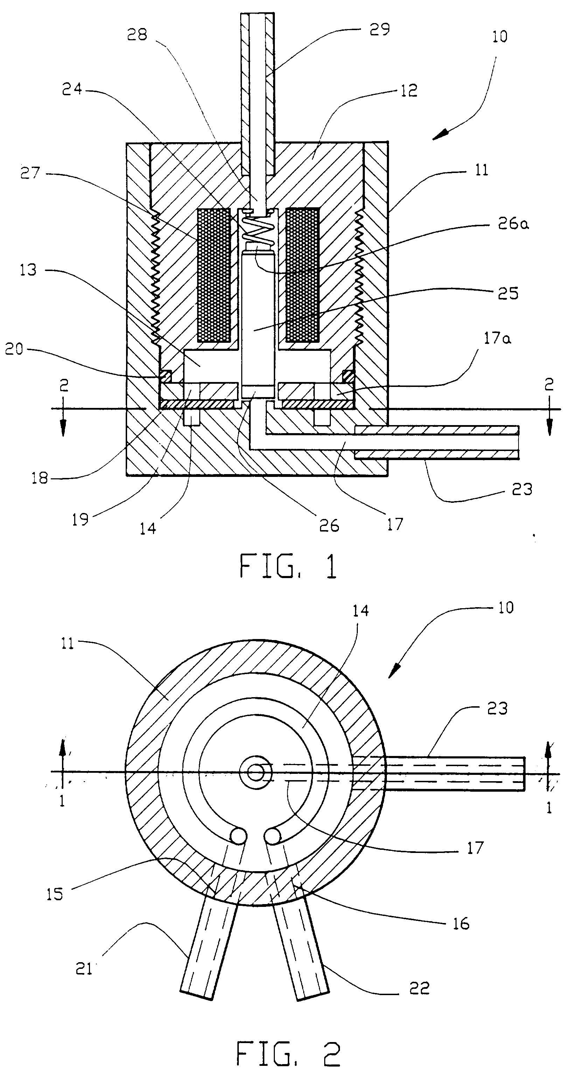

Referring now to Figs 1 and 2, therein is shown a valve and membrane device 10 comprising a housing 11 and a plug 1-2. The housing 11 and the plug 12 are provided with mating threads as shown. The housing 11 and the plug 12 form the body of the device 10 and define a cavity 13 therein. The housing 11 and the plug 12 are preferably made from stainless steel but can be made of almost any other suitable material such as another metal, a ceramic or a polymer. The housing 11 has a circular channel 14 machined in a bottom portion. However, the geometry of the channel is not critical and it could be in a spiral shape, a zigzag shape, a rectangular or other shape. The housing 11 has a first passageway 15 from the exterior of the housing 11 to one end of the channel 14 and a second passageway 16 from the exterior of the housing 11 to the other end of the channel 14. The housing 11 further has a third passageway 17 extending from the exterior of the housing 11 to the chamber 13. A washer 17a and a sheet membrane 18 are sandwiched between the plug 12 and the housing 11. A series of holes 19 are drilled in the washer 17a opposite the channel 14. An O-ring 20 seals the washer 17a, the housing 11 and the plug 12. One side of the membrane 18 is thus exposed to the chamber 13 via the holes 19 in the washer 17a while the other side of the membrane 18 is exposed to the channel 14. The plug 12 presses against the washer 17a which in turn is pressed against the membrane 18 which in turn is pressed against the bottom surface of the chamber 13 adjacent the channel 14 and thereby forms a continuous seal between the membrane 18 and the surface of the chamber 13 adjacent the channel 14. This is important since only membrane permeation communication between the channel 14 and the chamber 13 is desirable. A section of tubing 21 is joined with the housing 11 to extend the first passageway 15 and the tubing 21 is a part of the valve body. A section of tubing 22 is also joined with the housing 11 to extend the second passageway 16 and the tubing 22 is a part of the valve body. A section of tubing 23 is also joined with the housing 11 to extend the third passageway 17 and the tubing 23 is a part of the valve body. A coil spring 24 is positioned in a central channel of the plug 12 to urge a solenoid plunger 25 having a resilient seal 26 on an end thereof against the portion of the housing 11 where the third passageway enters the chamber 13 closing the third passageway 17. A terminal portion of the plunger 25 and the seal 26 extend into the chamber 13. The plug 12 has a fourth passageway 28 from the exterior of the plug 12 to the chamber 13. A section of tubing 29 is joined with the plug 12 to extend the passageway 28. A resilient seal 26a is positioned on the top of the plunger 25. A solenoid coil 27, when energized, pulls the plunger 25 and the seal 26 upward opening the third passageway 17 and closing the fourth passageway 28. Although the device 10 is shown as a solenoid valve it should be understood that this is not critical and that most any valve means can be used to controllably close or control the flow through the fourth and/or third passageways including a manually actuated valve, a pneumatically actuated valve or even a piezoelectrically operated valve.

To use the device 10 in a mass spectrometry system, the tubing 29 is connected to a vacuum pump and a sample containing a component that permeates across the membrane 18 is flowed into the tubing 21, through the channel 14 and out the tubing 22 while the vacuum inlet of the mass spectrometer is connected to the tubing 23. When the solenoid coil 27 is energized, the component of interest that permeates across the membrane 18 into the chamber 13 can flow through the passageway 17 into the mass spectrometer. Connecting a vacuum pump to the tubing 29 is preferred in this application to prevent a pressure surge into the mass spectrometer when the solenoid coil 27 is energized. Several valves of the present invention can be connected to the vacuum inlet of a mass spectrometer so that each can be analyzed as desired.

In some applications, the heat generated by the solenoid coil 27 can be a problem because permeation across the membrane 18 can vary with temperature. A solution to this problem that has been found to be effective is to cool the solenoid coil 27 with coolant pumped through a tube coil positioned below the solenoid coil 27. Alternatively, a pneumatically actuated valve can be used.

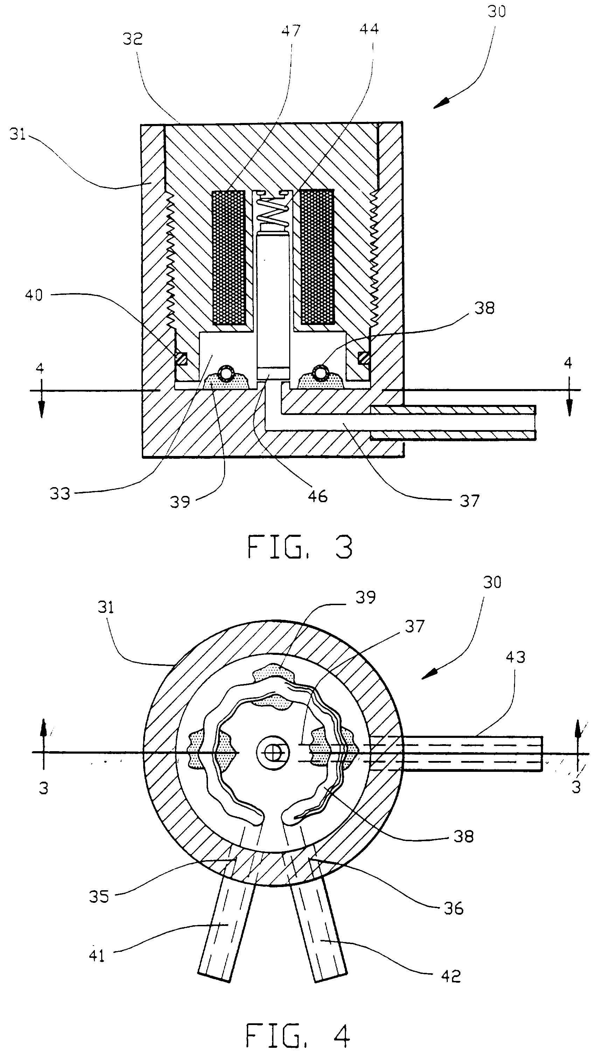

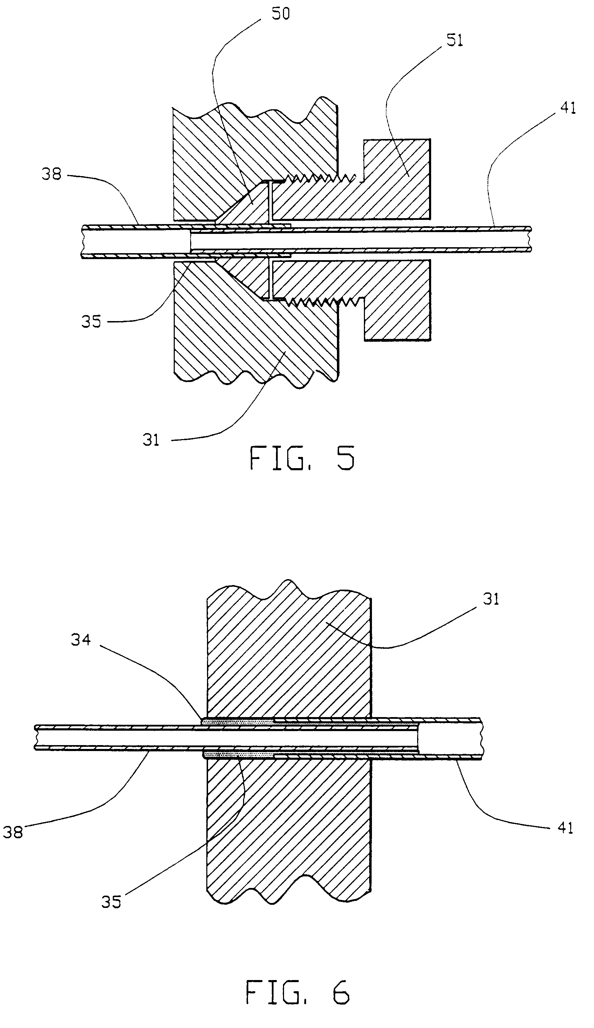

Referring now to Fig. 3 and 4, therein is shown a device 30, similar in many respects to the device 10 shown in Fig. 1 and 2, incorporating a housing 31 and a plug 32. The housing 31 and the plug 32 are provided with mating threads as shown. The housing 31 and the plug 32 form the body of the device 30 and define a cavity 33 therein. The housing 31 has a first passageway 35 from the exterior of the housing 31 to the cavity 33. The housing 31 also has a second passageway 36 from the exterior of the housing 31 to the chamber 33. The housing 31 further has a third passageway 37 from the exterior of the housing 31 to the chamber 33. An O-ring 40 seals the housing 31 to the plug 32. A tubular membrane 38 is positioned with one end portion in the first passageway 35 and the other end portion in the second passageway 36. The outer end portions of the membrane 38 need to be continuously sealed to the inside surfaces of the passageways 35 and 36 since only membrane permeation communication between the bore of the membrane 38 and the chamber 33 is desirable. Two alternatives for such sealing will be discussed below with reference to Fig. 5 and 6. The central portion of the tubular membrane 38 is secured to the bottom surface of chamber 33 with a room temperature vulcanizing silicone rubber sealant 39. A section of tubing 41 is joined with the housing 31 to extend the first passageway 35 and the tubing 41 is a part of the valve body. A section of tubing 42 is also joined with the housing 31 to extend the second passageway 36 and the tubing 42 is a part of the valve body. A section of tubing 43 is also joined with the housing 31 to extend the third passageway 37 and the tubing 43 is a part of the valve body. A coil spring 44 is positioned in a central channel of the plug 32 to urge a solenoid plunger having a resilient seal 46 on an end thereof against the portion of the housing 31 where the third passageway enters the chamber 33 closing the third passageway 37. The plunger and its seal 46 are thus positioned within the cavity 33. A solenoid coil 47, when energized, pulls the plunger 45 and the seal 46 upward opening the third passageway 37. Although the device 30 is shown as a solenoid valve it should be understood that this is not at all critical and that most any valve can be used to control flow in the third passageway including a manually actuated valve, a pneumatically actuated valve or even a piezoelectrically operated valve.

Referring now to Fig. 6, a room temperature vulcanizing silicone rubber sealant 34 is used to seal the tubular membrane 38 in the passageway 35 and in the tubing 41. In the embodiment of Fig. 5, the tube 41 is dimensioned to fit inside the tubular membrane 38 to form a portion where the membrane 38 overlaps the end portion of the tube 41. The portion where the membrane 38 overlaps the tube 41 is placed within a ferrule 50. A nut 51 compresses the ferrule 50 to seal the overlapping portion of the tubular membrane 38 to the tubing 41. The embodiment of Fig. 5 allows easier replacement of the membrane 38 in the valve 30.

It should be understood that the apparatus of the present invention can be used in many applications in addition to those mentioned above. For example, it could be used on the inlet of a gas chromatography system to introduce a permeated component of interest into a gas chromatography column or into the injection valve of a gas chromatography system. Additionally, it could be incorporated into a probe inserted directly into the vacuum chamber of a mass spectrometer.

The membrane of the present invention must be a selectively permeable membrane and not an impermeable membrane such as a sheet metal diaphragm of the type that has long been used in valves such as pressure regulation valves. The membrane of the present invention can be nonporous or porous as long as it is selectively permeable to the component of interest, i.e., that the rate of permeation of the component of interest across the membrane be different than the rate of permeation across the membrane of another component.

Sheet and tubular membranes of nonporous silicone rubber are preferred examples. Other examples of suitable membrane materials include porous polyethylene membranes (such as Celgard brand sheet or tubular membranes from the Celanese Corporation of the United States of America), membranes made from polytetrafluoroethylene, polycarbonate, other rubbers and ion exchange polymers (such as Nafion brand ion exchange membranes from DuPont of the United States of America). Many other examples of suitable membranes can be found commercially available or described in publications such as Membranes in Separations by professors Hwang and Kammermeyer published by Krieger in 1984.

## Claims

1. A valve and membrane device, comprising:
(a) a semipermeable membrane having a first side and a second side;
(b) a valve body defining a cavity therein, said cavity being partitioned by the membrane into a first cavity portion exposed to said first side of said membrane and a second cavity portion exposed to said second side of said membrane, said valve body having first, second and third passageways extending thereinto, said first and second passageways opening into said first cavity portion, said third passageway opening into said second cavity portion for flow of a fluid through said first passageway into said first cavity portion and then through said second passageway and for permeation of a fluid component across said membrane into said second cavity portion for flow out of said valve body through said third passageway; and
(c) means positioned within said cavity for controlling the flow of said fluid component through said third passageway.

2. The valve and membrane device of Claim 1 wherein said means for controlling the flow of said fluid component through said third passageway includes a solenoid actuated plunger.

3. The valve and membrane device of Claim 2 wherein said valve body has a fourth passageway thereinto and a means for controlling flow of a fluid therethrough, said fourth passageway opening into said second cavity portion.

4. The valve and membrane device of Claim 3 wherein said means for controlling flow of a fluid therethrough includes a solenoid actuated plunger.

5. The valve and membrane device of Claim 1 wherein said membrane is a sheet type membrane.

6. The valve and membrane device of Claim 1 wherein said membrane is a tubular type membrane.

## Patentansprüche

1. Eine Ventil- und Membranvorrichtung enthaltend :
(a) eine semipermeable Membran mit einer ersten Seite und einer zweiten Seite,
(b) einen Ventilkörper, der einen Hohlraum darin definiert, wobei dieser Hohlraum durch die Membran in einen ersten Hohlraumteil, der an diese erste Seite dieser Membran angrenzt, und einen zweiten Hohlraumteil, der an diese zweite Seite dieser Membran angrenzt, aufgeteilt wird, dieser Ventilkörper erste, zweite und dritte Durchführungen aufweist, die sich darinhinein erstrecken, wobei sich diese ersten und zweiten Durchführungen in diesen ersten Hohlraumteil öffnen und diese dritte Durchführung sich in diesen zweiten Hohlraumteil öffnet für den Durchfluß eines Fluids durch diese erste Durchführung in diesen ersten Hohlraumteil und dann durch diese zweite Durchführung und zur Permeation einer Fluidkomponente durch diese Membran in diesem zweiten Holraumteil und zum Fluß aus diesem Ventilkörper hinaus durch diese dritte Durchführung, und
(c) eine Einrichtung, die innerhalb dieses Hohlraums angeordnet ist, um den Fluß dieser Fluidkomponente durch diese dritte Durchführung zu regeln.

2. Die Ventil- und Membranvorrichtung nach Anspruch 1,
**dadurch gekennzeichnet,**
daß diese Einrichtung zum Regeln des Flusses der Fluidkomponente durch diese dritte Durchführung einen Solenoid betätigten Ventilkolben beinhaltet.

3. Die Ventil- und Membranvorrichtung nach Anspruch 2,
**dadurch gekennzeichnet,**
daß dieser Ventilkörper eine vierte Durchführung hierinhinein aufweist und eine Einrichtung zur Regelung des Flusses eines Fluids hierdurch, wobei diese vierte Durchführung sich in diesen zweiten Hohlraumteil öffnet.

4. Die Ventil- und Membranvorrichtung nach Anspruch 3,
**dadurch gekennzeichnet,**
daß diese Einrichtung zur Regelung des Flusses eines Fluids hierindurch einen Solenoid betätigten Ventilkolben beinhaltet.

5. Die Ventil- und Membranvorrichtung nach Anspruch 1,
**dadurch gekennzeichnet,**
daß diese Membran eine folienförmige Membran ist.

6. Die Ventil- und Membranvorrichtung nach Anspruch 1,
**dadurch gekennzeichnet,**
daß diese Membran eine röhrenförmige Membran ist.

## Revendications

1. Dispositif à soupape et membrane comprenant :
(a) une membrane semi-perméable comportant un premier côté et un second côté ;
(b) un corps de soupape dans lequel est ménagée une cavité qui est divisée par la membrane en une première partie de cavité communiquant avec ledit premier côté de ladite membrane et en une seconde partie de cavité communiquant avec ledit second côté de ladite membrane, ledit corps do soupape comportant des premier, deuxième et troisième passages qui le traversent, lesdits premier et deuxième passages débouchant dans ladite première partie de cavité, ledit troisième passage débouchant dans ladite seconde partie do cavité pour permettre à un fluide d'emprunter ledit premier passage, de passer dans ladite première partie de cavité, puis de traverser ledit deuxième passage et pour permettre à un composant du fluide de traverser par perméation ladite membranes de passer dans ladite seconde partie de cavité et de quitter le corps de soupape par ledit troisième passage ; et
(c) des moyens disposés à l'intérieur de ladite cavité pour régler le débit dudit composant du fluide à travers ledit treizième passage.

2. Dispositif à soupape et membrane selon la revendication 1, caractérisé en ce que le moyen pour régler le flux dudit composant du fluide à travers ledit troisième passage est un plongeur actionné par un solénoïde.

3. Dispositif à soupape et membrane selon la revendication 2, caractérisé en ce que ledit corps de soupape comporte un quatrième passage et un moyen pour régler le flux d'un fluide à travers ledit corps de soupape, ledit quatrième passage débouchant dans ladite seconde partie de cavité.

4. Dispositif à soupape et membrane selon la revendication 3, caractérisé en ce que ledit moyen pour régler le flux de fluide à travers ladite soupape à membrane est un plongeur actionné par un solénoïde.

5. Dispositif à soupape et membrane selon la revendication 1, caractérisé en ce que ladite membrane est une membrane de type feuille.

6. Dispositif à soupape et membrane selon la revendication 1, caractérisé en ce que ladite membrane est une membrane de type tubulaire.
